# EUROPÄISCHE PATENTSCHRIFT

(11) **EP 2 606 329 B1**
(45) Veröffentlichungstag und Bekanntmachung des Hinweises auf die Patenterteilung: **12.09.2018**
(21) Anmeldenummer: 11739032.8
(22) Anmeldetag: 20.07.2011
(51) Int. Cl.: G01L 19/00, G01L 19/06, H01L 29/84

(54) **SENSORMODUL ZUR AUFNAHME EINES DRUCKSENSORCHIPS UND ZUR MONTAGE IN EINEM SENSORGEHÄUSE**
SENSOR MODULE FOR RECEIVING A PRESSURE SENSING CHIP AND FOR ASSEMBLING IN A SENSOR HOUSING
MODULE CAPTEUR POUR LOGER UNE PUCE DE CAPTEUR DE PRESSION ET À MONTER DANS UN BOÎTIER DE CAPTEUR

(30) Priorität: 20.08.2010 DE 102010039599
(43) Veröffentlichungstag der Anmeldung: 26.06.2013
(73) Patentinhaber: Robert Bosch GmbH, 70442 Stuttgart (DE)
(72) Erfinder: WELTER, Aline, 99817 Eisenach (DE); LUX, Alexander, 73760 Ostfildern (DE); GMELIN, Christoph, 70597 Stuttgart (DE); VOLLERT, Jens, 99974 Muehlhausen (DE); HERRMANN, Reinhold, 70469 Stuttgart (DE); SCHELLKES, Eckart, 72070 Tuebingen (DE)
(86) Internationale Anmeldenummer: PCT/EP2011/062423
(87) Internationale Veröffentlichungsnummer: WO 2012/022572

(56) Entgegenhaltungen:
- JP-A- H07 245 377
- JP-A- 2004 165 525
- US-A- 5 859 759
- US-A1- 2006 213 276
- US-A1- 2008 006 939

## Beschreibung

### Stand der Technik

Die Erfindung geht aus von einem Sensormodul zur Aufnahme eines Drucksensorchips und zur Montage in einem Sensorgehäuse, nach Gattung des unabhängigen Anspruchs.

Gegenstand der vorliegenden Erfindung ist ferner ein System umfassend solch ein Sensormodul und zumindest zwei Sensorgehäuse.

Aus der DE 10 2004 012 593 A1 und aus der US 5 85 759 A ist bereits ein Sensormodul bekannt, welches in ein Sensorgehäuse montierbar ist. Das Sensorgehäuse weist zwei voneinander getrennte Innenräume auf und ist mit darin eingebetteten elektrischen Leitern versehen. Einer der Innenräume ist mit zumindest einem Kondensator versehen, wobei das Sensormodul im anderen Innenraum angeordnet ist. In dem Sensormodul ist ein als Halbleiter-Druckaufnehmer fungierender Siliciumchip montiert, auf dem druckempfindliche Elemente angeordnet sind. Das Sensormodul ist eine oben offene, kastenförmige Schale, welche aus einem Boden und einer den Sensorchip umlaufenden Wand gebildet wird. Das Sensormodul besteht beispielsweise aus Kunststoff und weist Anschlusselemente auf, die von der Innenseite ausgehend durch die umlaufende Wand nach außen, in den Innenraum des Sensorgehäuses geführt sind und dort mit den eingebetteten elektrischen Leitern durch Löten oder Presskontaktierung verbunden sind. Die Anschlusselemente werden nach dem Verbinden mit Kleber abgedeckt. Das Sensormodul wird zum Schutz des Sensorchips mit Gel gefüllt und somit der Sensorchip darin eingebettet.

### Offenbarung der Erfindung

Das erfindungsgemäße Sensormodul zur Aufnahme eines Drucksensorchips und zur Montage in einem Sensorgehäuse weist einen Modulboden auf, wobei der Modulboden einen Chipmontagebereich hat, auf dem der Drucksensorchip montierbar ist. Ferner weist das Sensormodul eine monolithisch mit dem Modulboden ausgebildete und den Chipmontagebereich umlaufende Modulwand auf. Durch die Modulwand sind mehrere nach außen geführte Anschlusselemente geführt. Die Anschlusselemente verlaufen zumindest im gesamten Außenbereich gerade. Dabei sind die Anschlusselemente auf beiden Seiten, welche in entgegengesetzte Richtungen entlang einer Normalen zum Modulboden weisen, zumindest abschnittsweise zum Aufbringen und elektrischen Verbinden zumindest eines elektrischen Bauteils und zur elektrischen Einbindung des Sensormoduls in das Sensorgehäuse freigelegt. Bei dem zumindest einen elektrischen Bauteil handelt es sich um zumindest einen Kondensator, es können aber alternativ oder zusätzlich auch ein oder mehrere Widerstände, Dioden oder andere elektrische Bauteile vorgesehen sein, die zwei Anschlüsse haben und als SMD-Elektronikbauteile erhältlich sind. Dieses Sensormodul hat gegenüber dem Stand der Technik den Vorteil, dass es in beiden Orientierungen, d.h. mit der offenen Seite (Gelseite) nach oben oder unten verbaubar und elektrisch anschließbar ist. Dadurch erreicht man einen hohen Grad an Flexibilität bei der ein gesamtes Sortiment verschiedener Sensoranwendungen mit Sensormodulen gleicher Geometrie und Anschlüssen und somit einer einzigen dafür erforderlichen Gussform realisierbar ist. Somit sind Sensoren für verschiedene Applikationen nach einem Baukastenprinzip realisierbar. Dadurch, dass nur eine Gussform für mehrere Applikationen erforderlich ist (nur ein Premoldwerkzeug), können die Herstellungskosten gesenkt werden. Durch die Möglichkeit des Einbaus mit der offenen Seite (Gelseite) nach unten kann ferner eine höhere Medienresistenz erreicht werden, da Flüssigkeitsansammlungen auf dem Gel ungehindert ablaufen bzw. abtropfen können. Durch die verminderte Gefahr von Flüssigkeitsansammlungen kann ferner die Vereisungsgefahr verringert werden.

Mit dem erfindungsgemäßen System mit den Merkmalen des nebengeordneten Anspruchs lassen sich ebenfalls die genannten Vorteile erreichen.

Durch die in den abhängigen Ansprüchen aufgeführten Maßnahmen sind vorteilhafte Weiterbildungen und Verbesserungen der im unabhängigen Anspruch und im nebengeordneten Anspruch definierten Vorrichtungen angegeben.

Gemäß einem Ausführungsbeispiel ist dabei das Sensormodul des Weiteren mit einer Öffnung versehen, die sich durch den Modulboden erstreckt und im Chipmontagebereich in das Sensormodul mündet. Dadurch kann beispielsweise das Sensormodul mit der Gelseite nach oben verbaut werden und ein am Modulboden anliegender Druck gemessen werden. Darüber hinaus eröffnet diese Maßnahme die Möglichkeit einer Differenzdruckmessung zwischen einem an der Gelseite und am Modulboden anliegenden Druck. Somit wird ermöglicht, dass die Druckzufuhr und die elektrische Anbindung auf jeweils unterschiedlichen Seiten des Sensormoduls positioniert sind, wodurch eine gesteigerte Medienrobustheit und höhere Flexibilität bezüglich Variantenvielfalt erreicht wird.

Gemäß einem weiteren Ausführungsbeispiel wird ein Sensormodul bereitgestellt, bei dem der Modulboden und die Modulwand monolithisch gegossen sind und sich im Außenbereich zwischen den Anschlusselementen ebenfalls Gussmaterial befindet. Dies das den Vorteil, dass die Anschlusselemente besser fixiert und gehalten werden. Ein Verbiegen der Anschlusselemente kann somit beim Einsetzen in das Sensorgehäuse vermieden und ein sicherer Kontakt erreicht werden. Außerdem werden die Anschlusselemente gegeneinander besser isoliert und ein kompakteres Sensormodul bereitgestellt.

Vorteilhafterweise befindet sich dabei im Außenbereich, über zumindest 80% der Länge der Anschlusselemente im Außenbereich, zwischen den Anschlusselementen Gussmaterial. Dies führt zu einer weiteren Verbesserung der im vorherigen Absatz genannten Vorteile.

Gemäß einem weiteren Ausführungsbeispiel befindet sich dabei im Außenbereich, über die gesamte Länge der Anschlusselemente im Außenbereich, zwischen den Anschlusselementen Gussmaterial.

Gemäß einem weiteren Ausführungsbeispiel wird ein Sensormodul bereitgestellt, bei dem die Anschlusselemente im Außenbereich mit Gussmaterial umgeben sind und nur die nach außen weisenden Endbereiche der Anschlusselemente auf beiden Seiten, welche in entgegengesetzte Richtungen entlang einer Normalen zum Modulboden weisen, sowie ein zum Aufbringen des zumindest einen elektrischen Bauteils, vorzugsweise zumindest eines Kondensators, ausgesparter Bereich, freigelegt sind. Dadurch sind die Anschlusselemente weitgehend eingebettet und geschützt. Dies führt zu einer guten Fixierung und gegenseitigen Isolation. Ferner kann die Ummantelung der Anschlusselemente als Schablone dienen, so dass die Form der Ummantelung so auf eine Form der Innenflächen des Sensorgehäuses angepasst ist, dass die Kontaktflächen der jeweiligen Anschlusselemente beim Einsetzen zu den jeweils vorgesehenen sensorgehäuseseitigen Kontaktflächen hingeführt werden.

Gemäß einem weiteren Ausführungsbeispiel wird ein Sensormodul bereitgestellt, wobei sich der Umfang des Sensormoduls ausgehend von der nach außen weisenden Seite des Modulbodens in einer Richtung normal zum Modulboden zunächst vergrößert und dann verjüngt. Somit kann das Sensormodul in verbesserter Art und Weise in eine entsprechende sensorgehäuseseitige Ausnehmung eingesetzt werden und hat diesbezüglich einen verbesserten Sitz.

Gemäß einem weiteren Ausführungsbeispiel wird ein System mit einem solchen Sensormodul und zumindest zwei Sensorgehäuse bereitgestellt, wobei die zumindest zwei Sensorgehäuse auf ihrer Innenseite eine Vertiefung aufweisen, wobei die nach außen weisende Seite des Modulbodens geometrisch an die Vertiefung des einen Sensorgehäuses angepasst ist, und der in die entgegengesetzte Richtung weisende Bereich der Modulwand geometrisch an die Vertiefung des anderen Sensorgehäuses angepasst ist. Dadurch kann eine doppelseitige Verwendung des Sensormoduls realisiert werden, bei der zusätzlich ein fehlerhaftes Einsetzen vermieden wird. Durch die Anpassung eines Sensorgehäuses mit der Gelseite des Sensormoduls und die Anpassung eines unterschiedlichen Sensorgehäuses mit der Bodenseite des Sensormoduls ist somit bei beidseitiger Verwendungsmöglichkeit des Sensormoduls jede Seite eindeutig dem passenden Sensorgehäuse zugeordnet.

Gemäß einem weiteren Ausführungsbeispiel wird ein System geschaffen, wobei die Seitenwände das Sensormoduls auf einer Seite, bezüglich einer Ebene in der die Anschlusselemente liegen, eine erste Neigung und auf der anderen Seite eine zweite Neigung gegenüber einer Normalen zum Modulboden aufweisen, und die Seitenwände der Vertiefung des einen Sensorgehäuses die erste Neigung und die Seitenwände der Vertiefung des anderen Sensorgehäuses die zweite Neigung aufweisen. Dies verbessert die beschriebene Zuordnung zu verschiedenen Sensorgehäusen noch weiter.

Ausführungsbeispiele der Erfindung sind in den Zeichnungen dargestellt und in der nachfolgenden Beschreibung näher erläutert.

Es zeigen
- Figur 1a: ein erstes Ausführungsbeispiel des Sensormoduls in einem Saugrohrdruck-Sensorgehäuse,
- Figur 1b: das erste Ausführungsbeispiel des Sensormoduls in einem Absolutdruck-Sensorgehäuse mit Kappenchip,
- Figur 1c: das erste Ausführungsbeispiel des Sensormoduls in einem Bremskraftverstärker-Sensorgehäuse,
- Figur 1d: das erste Ausführungsbeispiel des Sensormoduls in einem Tankdruck-Sensorgehäuse,
- Figur 2: eine dreidimensionale Darstellung des Sensormoduls gemäß dem ersten Ausführungsbeispiel der Erfindung,
- Figur 3: eine dreidimensionale Darstellung eines Sensorgehäuses mit eingebautem Sensormodul gemäß dem ersten Ausführungsbeispiel der Erfindung,
- Figur 4: eine dreidimensionale Darstellung eines Sensormoduls gemäß einem zweiten Ausführungsbeispiel der Erfindung,
- Figur 5: eine dreidimensionale Darstellung eines Sensorgehäuses mit eingebautem Sensormodul gemäß dem zweiten Ausführungsbeispiel der Erfindung,
- Figur 6: eine dreidimensionale Darstellung eines Sensorgehäuses mit eingebautem Sensormodul gemäß dem zweiten Ausführungsbeispiel der Erfindung,
- Figur 7: eine dreidimensionale Darstellung eines Sensormoduls gemäß einem dritten Ausführungsbeispiel der Erfindung,
- Figur 8a: eine dreidimensional dargestellte Unterseite eines Sensormoduls gemäß einem vierten Ausführungsbeispiels der Erfindung, und
- Figur 8b: eine dreidimensional dargestellte Oberseite des Sensormoduls gemäß dem vierten Ausführungsbeispiel der Erfindung.

### Ausführungsformen der Erfindung

In der nachfolgenden Figurenbeschreibung bezeichnen gleiche Bezugszeichen auch gleiche Bauteile. Somit gilt die Beschreibung eines Elements im Zusammenhang mit einer Figur auch für die anderen Figuren, wenn es dasselbe Bezugszeichen trägt und/oder in gleicher Weise dargestellt ist.

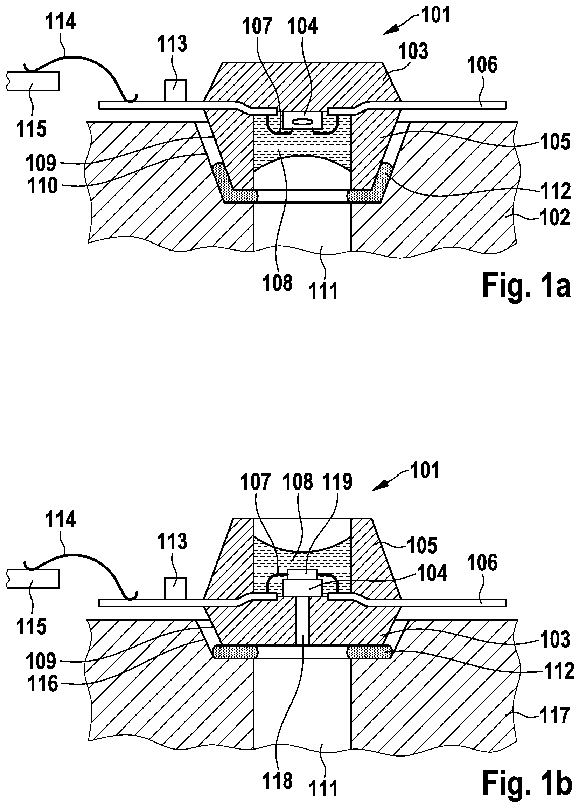

Die Figuren 1a bis 1d zeigen Schnittdarstellungen durch das Zentrum der nachfolgend erläuterten Öffnung im Boden des Sensormoduls und parallel zur Längsrichtung der Anschlusselemente. Figur 1a zeigt ein erstes Ausführungsbeispiel des Sensormoduls 101 in einem Saugrohrdruck-Sensorgehäuse 102. Es handelt sich dabei um einen Drucksensor, der einen Saugrohr-Absolutdruck bei Verbrennungsmotoren misst. Das Sensormodul 101 ist eine kastenförmige Schale mit quadratischem Modulboden 103. Auf der nach innen gewandten Seite des Modulbodens 103 ist ein Drucksensorchip 104 auf einem dafür vorgesehenen Chipmontagebereich, beispielsweise mittels Silikonkleber, befestigt. Der Drucksensorchip 104 ist vorzugsweise ein poröser Siliciumchip. Vom Modulboden 103 erstreckt sich eine mit diesem monolithisch ausgebildete und den Drucksensorchip 104 umlaufende Modulwand 105. Somit wird das Sensormodul 101 als eine einseitig offene Schale mit quadratischer Grundfläche ausgebildet. Seitenflächen 109 des Sensormoduls 101 sind mit einer Neigung gegenüber einer Normalen zum Modulboden 103 (d.h. der Vertikalen in Fig. 1a) so ausgebildet, dass sich der Umfang des Sensormoduls 101 innerhalb einer Ebene parallel zum Modulboden 103, ausgehend vom Modulboden 103 zunächst vergrößert und dann verkleinert. Im Bereich des größten Umfangs sind Anschlusselemente 106 vorgesehen, die sich aus dem hohlen Innenraum des Sensormoduls 101 durch die Modulwand 105 nach außen erstrecken. Im gesamten Außenbereich, also außerhalb der Modulwand 105, verlaufen die Anschlusselemente 106 gerade (ohne Biegung und ohne Knicke), vorzugsweise parallel zum Modulboden 103. Die Anschlusselemente bestehen aus elektrisch leitendem Material, beispielsweise Kupfer. Das innenseitige Ende der Anschlusselemente 106 führt zum inneren Hohlraum des Sensormoduls 101 und ist im Bereich des Innenraumbodens freigelegt. Der Drucksensorchip 104 ist mittels Bonddrähten 107 entweder direkt oder über einen nicht dargestellten ASIC-Chip mit den Anschlusselementen 106 verbunden. Nach dem Herstellen dieser Verbindung wird der Innenraum des Sensormoduls 101 zumindest teilweise mit Gel 108 gefüllt, so dass die Bonddrähte 107 und der Drucksensorchip 104 im Gel eingebettet sind. Das Sensorgehäuse 102 ist mit einer Vertiefung 110 versehen, die an die Form des Sensormoduls 101, im Bereich der dem Modulboden 103 abgewandten Seite, angepasst ist. Insbesondere weist die Vertiefung 110 eine Tiefe auf, die der Distanz von den Anschlusselementen 106 bis zu der dem Modulboden 103 abgewandten Seite (entlang der Normalen) entspricht. Die Neigung der Seitenflanken der Vertiefung 110 entspricht derjenigen der sich in der Vertiefung 110 befindlichen (im eingesetzten Zustand) Seitenflächen 109 des Sensormoduls 101. Die Bodenfläche der Vertiefung 110 entspricht hinsichtlich Fläche und Form in etwa der dem Modulboden 103 abgewandten Seite. Im Zentrum des Bodens der Vertiefung 110 mündet ein Messkanal 111 in dem der zu messende Druck vorherrscht. Das Sensormodul 101 wird mit der offenen Seite zur Vertiefung (zum Boden der Vertiefung) gewandt in die Vertiefung eingesetzt. Der Querschnitt des Messkanals (d.h. senkrecht zu seiner Längsrichtung) entspricht in etwa dem Querschnitt des offenen Innenraums des Sensormoduls 101, so dass der Innenraum des Sensormoduls 101 mit dem Messkanal 111 im eingesetzten Zustand des Sensormoduls 101 bündig ist. Die an die Innenseite der Vertiefung 110 anliegende Fläche des Sensormoduls 101 bildet eine Klebefläche, die mit einem Klebstoff 112, vorzugsweise Silikonkleber, in die Vertiefung geklebt wird. Auf der der Klebefläche abgewandten Seite der Anschlusselemente 106 sind Kondensatoren 113 als bevorzugte elektrische Bauteile aufgebracht, wobei ein Anschluss des Kondensators 113 mit einem Anschlusselement elektrisch verbunden ist und der andere Anschluss desselben Kondensators 113 mit einem benachbarten Anschlusselement 106 elektrisch verbunden ist. Mittels Bonddrähten 114 sind die Anschlusselemente 106 elektrisch mit sensorgehäuseseitigen, elektrischen Kontakten 115 verbunden und somit elektrisch in das Sensorgehäuse 102 eingebunden. Diese gehäuseseitigen, elektrischen Kontakte 115 werden im Sensorgehäuse 102 zu anderen elektronischen Elementen oder sensorgehäuseexternen Elementen weitergeführt.

Figur 1b zeigt das erste Ausführungsbeispiel des Sensormoduls 101 in einem Absolutdruck-Sensorgehäuse mit Kappenchip (Sensorelement mit Referenzvakuum unter einer Kappe und Wirkdruck von unten). Im Unterschied zu Figur 1a ist in Figur 1b das Sensormodul 101 mit umgekehrter Ausrichtung, d.h. mit seiner offenen Seite von einer Vertiefung 116 eines Sensorgehäuses 117 weg weisend in die Vertiefung eingesetzt. Das Sensorgehäuse 117 unterscheidet sich vom Sensorgehäuse 102 dadurch, dass die Vertiefung an die Form des Sensormoduls 101, im Bereich des Modulbodens 103, angepasst ist. Die Vertiefung 116 weist eine Tiefe auf, die der Distanz (entlang der Normalen zum Modulboden) von den Anschlusselementen 106 zur Außenseite des Modulbodens 103 entspricht. Die Seitenflanken der Vertiefung 116 haben die gleiche Neigung wie die sich in der Vertiefung befindlichen Seitenflächen des Sensormoduls 101. Die Außenseite des Modulbodens 103 fungiert in dieser Applikation als Klebefläche und wird mit Klebstoff 112 in der Vertiefung 116 fixiert. Im Unterschied zum Sensormodul 101 aus Figur 1a weist das Sensormodul 101 in Figur 1b eine Öffnung 118 auf, die im Sensorchipmontagebereich in den Innenraum des Sensormoduls 101 mündet. Bezüglich ihrer Geometrie entsprechen die Sensormodule 101 aus Figur 1a und 1b einander, so dass dieselbe Gussform für beide verwendet werden kann. Hergestellt wird das Sensormodul aus Kunststoff. Bei der Ausführung aus Figur 1b wird lediglich beim Gießen ein Stift als Insert vorgesehen, so dass die Öffnung 118 entsteht. Alternativ dazu könnte die Öffnung 118 immer vorgesehen sein und im Falle der Applikation aus Figur 1a mit einem Stift oder mit Klebstoff verschlossen werden. In Figur 1b ist auf dem Drucksensorchip 104 (d.h. auf der der Öffnung 118 abgewandten Seite des Chips) eine Kappe 119 mit einem Referenzvakuum aufgebracht. Somit kann ein im Messkanal vorherrschender Druck über die Öffnung 118 an den Drucksensorchip 104 angelegt und gemessen werden. Der Vorteil dieser Messung über die Öffnung 118 besteht darin, dass das zu messende Fluid vollständig von der Elektronik im Innenraum des Sensorgehäuses 117 und von den darin befindlichen elektrischen Kontakten 106, 114, 115 getrennt werden kann. Die Kondensatoren 113 werden ebenfalls auf der der Klebefläche abgewandten Seite der Anschlusselemente 106 auf diese aufgebracht und mit diesen elektrisch verbunden.

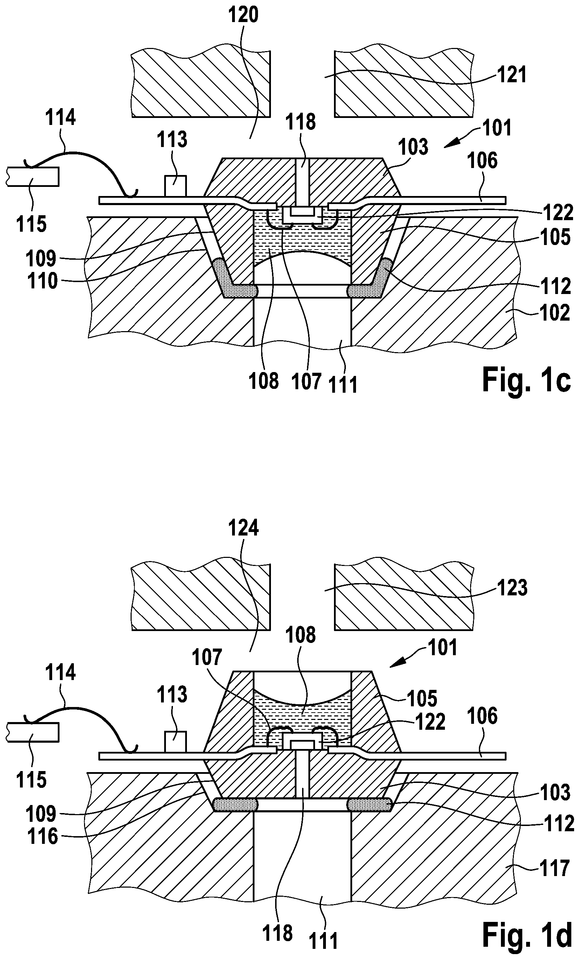

Figur 1c zeigt das erste Ausführungsbeispiel des Sensormoduls in einem Bremskraftverstärker-Sensorgehäuse. Die Ausrichtung entspricht der in Figur 1a beschriebenen. Im Unterschied zur Figur 1a ist bei dem Sensormodul 101 in Figur 1c die in Figur 1b beschriebene Öffnung 118 vorgesehen. An der offenen Seite des Sensormoduls 101 liegt somit der im Messkanal 111 vorherrschende Druck an, wohingegen an der Öffnung 118 ein Atmosphärendruck anliegt, so dass ein Differenzdruck zwischen diesen Drücken erfasst werden kann. Der Atmosphärendruck kann über eine Gehäuseöffnung 121 des Sensorgehäuses 102 in einen den Modulboden 103 umgebenden Innenraum 120 des Sensorgehäuses 102 geleitet werden. Für die Druckdifferenzmessung ist ein entsprechender Drucksensorchip 122 für Differenzdruckmessung vorgesehen.

Figur 1d zeigt das erste Ausführungsbeispiel des Sensormoduls in einem Tankdruck-Sensorgehäuse. Die Ausrichtung entspricht der in Figur 1b beschriebenen. An der Öffnung 118 des Sensormoduls 101 liegt der im Messkanal 111 vorherrschende Druck an, wohingegen an der offenen Seite des Sensormoduls 101 ein Atmosphärendruck anliegt, so dass ein Tankdruck (Differenzdruck) zwischen diesen Drücken erfasst werden kann. Der Atmosphärendruck kann über eine Gehäuseöffnung 123 des Sensorgehäuses 117 in einen die Gelseite des Sensormoduls umgebenden Innenraum 124 des Sensorgehäuses 117 geleitet werden. Für die Druckdifferenzmessung ist ein entsprechender Drucksensorchip 122 für Differenzdruckmessung vorgesehen. Durch die Messung über die Öffnung 118 kann der zu messende Kraftstoffdampf vollständig von der Elektronik im Innenraum des Sensorgehäuses und von den darin befindlichen elektrischen Kontakten 106, 114, 115 getrennt werden. Außerdem ist es vorteilhaft, wenn die sehr aggressiven Kraftstoffdämpfe nicht mit dem Gel 108 in Berührung kommen.

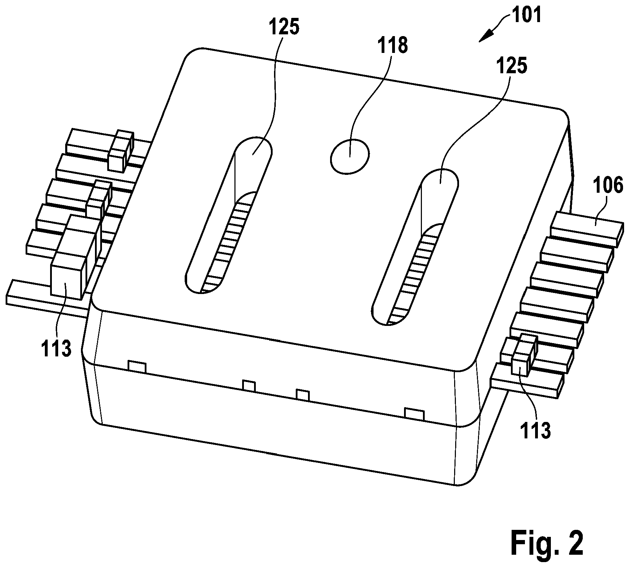

Figur 2 zeigt eine dreidimensionale Darstellung des Sensormoduls 101 gemäß dem ersten Ausführungsbeispiel der Erfindung. In dieser Darstellung sind die auf die Anschlusselemente 106 aufgebrachten Kondensatoren 113 gut erkennbar. Im Modulboden 103 befinden sich zwei Schlitze 125, die sich herstellungsbedingt ergeben. Die Schlitze 125 dienen zur Aufnahme von Vergussmasse, um einen darunter liegenden Leiterkamm zu halten und zu schützen.

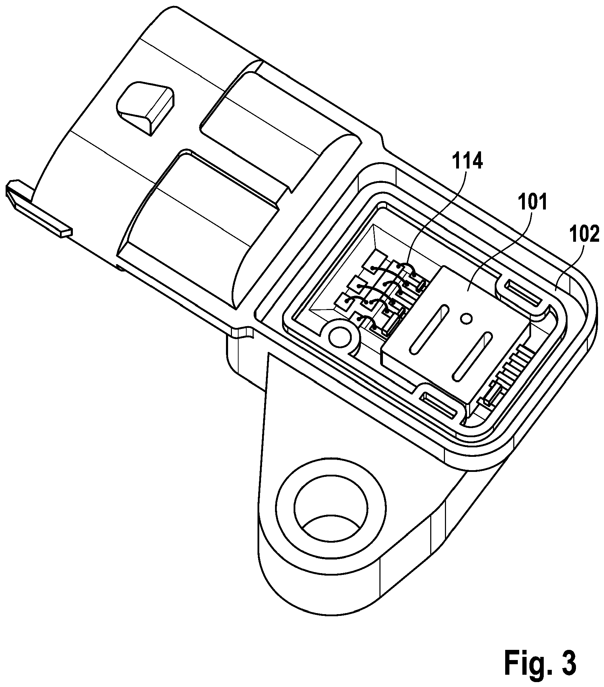

Figur 3 zeigt eine dreidimensionale Darstellung des Sensorgehäuses 102 mit eingebautem Sensormodul 101 gemäß dem ersten Ausführungsbeispiel der Erfindung. In Figur 3 ist die Einbaulage des Sensormoduls 102 dargestellt, bei der die offene Seite des Sensormoduls 101 in die Vertiefung 110 des Sensorgehäuses 102 zeigt. Die Anschlusselemente 106 werden über die beschriebenen Bonddrähte 114 mit den gehäuseseitigen elektrischen Kontakten verbunden.

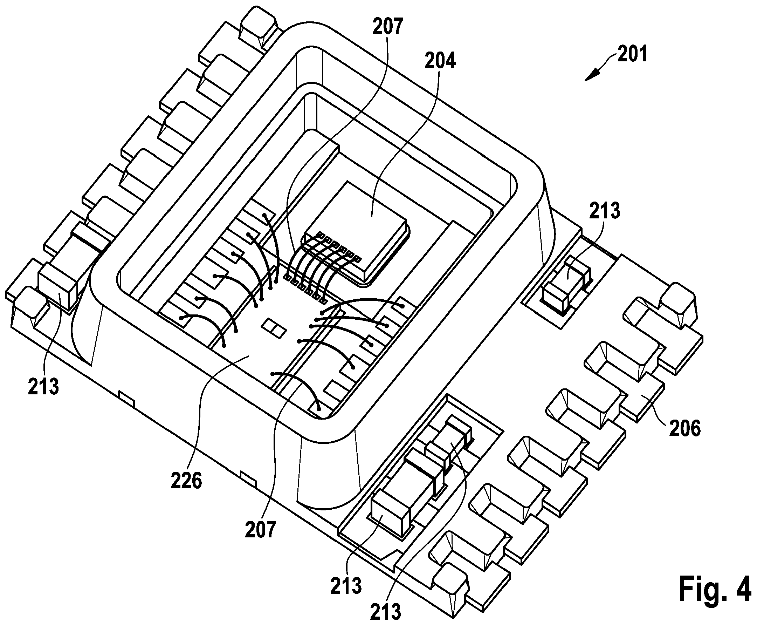

Figur 4 zeigt eine dreidimensionale Darstellung eines Sensormoduls 201 gemäß einem zweiten Ausführungsbeispiel der Erfindung. Für das Sensormodul 201 gilt die obige Beschreibung des Sensormoduls 101 und es werden lediglich die Unterschiede beschrieben. In diesem Ausführungsbeispiels ist über der Öffnung 118 (in Fig. 4 verdeckt) ein Drucksensorchip 204 angeordnet, der dem oben beschriebenen Drucksensorchip 104 oder 122 entspricht und mittels Bonddrähten 207 mit einem ASIC-Chip 226 verbunden ist (ASIC = Anwendungsspezifische Integrierte Schaltung). Der ASIC-Chip 226 wiederum ist mit Bonddrähten 207 mit den Anschlusselementen 206 verbunden, die den oben beschriebenen Anschlusselementen 106 entsprechen. Auf die Anschlusselemente 206 sind Kondensatoren 213 aufgesetzt, wie im Zusammenhang mit den Kondensatoren 113 beschrieben. Das zweite Ausführungsbeispiel unterscheidet sich im Wesentlichen vom ersten Ausführungsbeispiel der Erfindung dadurch, dass die Anschlusselemente 206 größtenteils mit dem gleichen Gussmaterial wie der Modulboden und die Modulwand umgossen sind, also monolithisch mit dem Modulboden und der Modulwand ausgebildet ist. Genauer bedeutet dies, dass sich zwischen den Anschlusselementen 206 Gussmaße befindet und lediglich ein nach außen gerichteter Endbereich der Anschlusslemente 206 über eine Länge (in Längsrichtung der Anschlusselemente 206) von 0,5 bis 2 mm nicht von Gussmaterial umgeben wird. Über einen daran anschließenden weiter innen liegenden Bereich mit einer Länge von 0,5 bis 2 mm ist zwischen den Anschlusselementen 206 Gussmaterial vorgesehen, jedoch die Ober- und Unterseite freigelegt. In diesem Bereich hat das zwischen den Anschlusselementen 206 befindliche Gussmaterial die gleiche Höhe wie im nachfolgenden Bereich, in dem die Anschlusselemente vollständig umgeben sind. Die Ober- und Unterseite entspricht dabei den in entgegengesetzte Richtungen entlang einer Normalen zum Modulboden weisenden Seiten. Der übrige Bereich der Anschlusselemente 206 ist vollständig von Gussmaterial eingehüllt, außer an den Stellen, an denen Kondensatoren 213 vorgesehen sind. Diese Bereiche sind zum Anbringen der Kondensatoren 213 ausgespart und die Anschlusselemente 206 sind in diesem Bereich freigelegt.

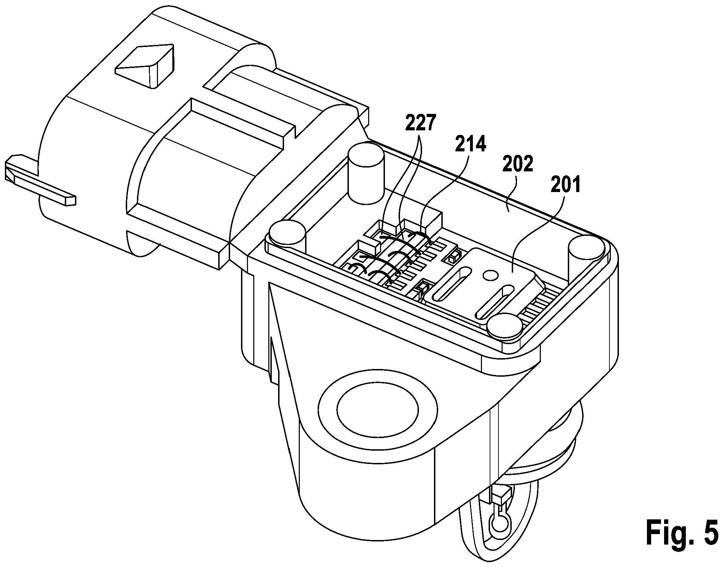

Figur 5 zeigt eine dreidimensionale Darstellung eines Sensorgehäuses 202 mit eingebautem Sensormodul 201 gemäß dem zweiten Ausführungsbeispiel der Erfindung. Für das Sensorgehäuse 202 gilt die Beschreibung des Sensorgehäuses 102. Figur 5 zeigt das Sensormodul 201 in der Einbaulage, bei der die offene Seite des Sensormoduls 201 in die Vertiefung des Sensorgehäuses 202 zeigt. Die Anschlusselemente 206 werden über die beschriebenen Bonddrähte 214 mit den gehäuseseitigen, elektrischen Kontakten 227 verbunden.

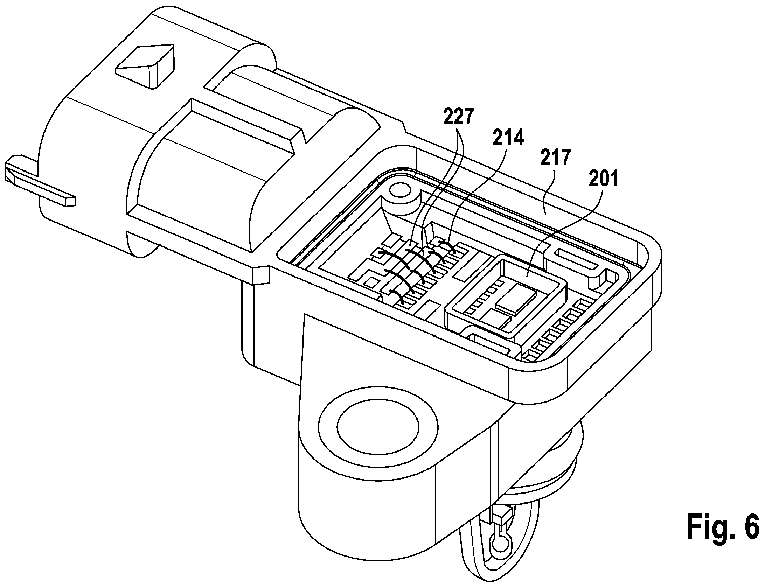

Figur 6 zeigt eine dreidimensionale Darstellung eines Sensorgehäuses 217 mit eingebautem Sensormodul 201 gemäß dem zweiten Ausführungsbeispiel der Erfindung. Für das Sensorgehäuse 217 gilt die Beschreibung des Sensorgehäuses 117. Figur 6 zeigt das Sensormodul 201 in der Einbaulage, bei der die offene Seite des Sensormoduls 201 von der Vertiefung des Sensorgehäuses 217 weg weist. Die Anschlusselemente 206 werden über die beschriebenen Bonddrähte 214 mit den gehäuseseitigen, elektrischen Kontakten 227 verbunden.

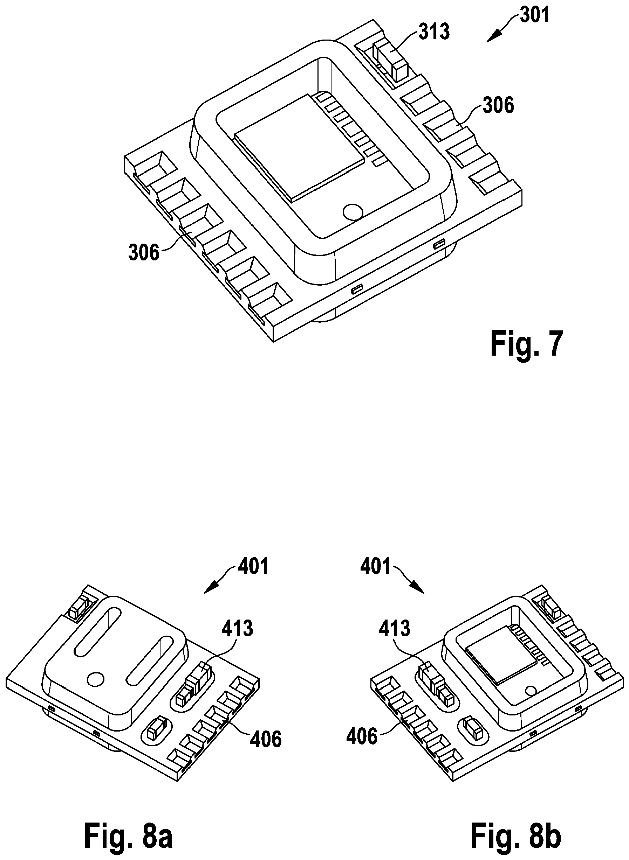

Figur 7 zeigt eine dreidimensionale Darstellung eines Sensormoduls 301 gemäß einem dritten Ausführungsbeispiel der Erfindung. Dieses dritte Ausführungsbeispiel unterscheidet sich vom in Figur 4 dargestellten, zweiten Ausführungsbeispiel dadurch, dass über die gesamte Länge im Außenbereich zwischen den Anschlusselementen 306, die den Anschlusselementen 106 entsprechen, Gussmaterial vorhanden ist. Somit existiert kein ringsum freigelegter Bereich der Anschlusselemente 306. In einem nach außen gerichteten Endbereich der Anschlusselemente 306, der sich über eine Länge von 0,5 bis 2 mm erstreckt, ist zwischen den Anschlusselementen 306 Gussmaterial vorgesehen jedoch die Ober- und Unterseite freigelegt. In diesem Bereich hat das zwischen den Anschlusselementen 306 befindliche Gussmaterial die gleiche Höhe wie im nachfolgenden Bereich, in dem die Anschlusselemente vollständig von Gussmaterial umgeben sind. Der übrige Bereich der Anschlusselemente 306 ist vollständig von Gussmaterial eingehüllt. Zur Montage der Kondensatoren 313 ist im oben erwähnten äußeren Endbereich der Anschlusselemente 306 zwar zwischen den Anschlusselementen 306 Gussmasse vorgesehen, jedoch nur in einer Höhe wie die Anschlusselemente 306 selbst.

Figur 8a zeigt eine dreidimensional dargestellte Unterseite eines Sensormoduls 401 gemäß einem vierten Ausführungsbeispiels der Erfindung, und Figur 8b zeigt eine dreidimensional dargestellte Oberseite des Sensormoduls gemäß dem vierten Ausführungsbeispiel der Erfindung. Dieses Ausführungsbeispiel unterscheidet sich vom dritten Ausführungsbeispiel nur in der Anbringung der Kondensatoren 413, die wie im zweiten Ausführungsbeispiel angebracht sind. Das heißt, sie werden nicht im äußeren Endbereich der Anschlusselemente 406 angebracht, sondern in dem Bereich, in dem die Anschlusselemente 406 vollständig von Gussmaterial eingehüllt sind, werden Stellen ausgespart, an denen die Kondensatoren 413 angebracht und elektrisch mit den an diesen Stellen freigelegten Anschlusselementen 406 verbunden.

Die Kondensatoren wurden in den obigen Ausführungsbeispielen immer im Plural beschrieben, es kann jedoch auch nur ein einziger Kondensator pro Sensormodul zum Einsatz kommen. Ferner können aber auch alternativ oder zusätzlich ein oder mehrere Bauteile der Gruppe bestehend aus Widerständen, Dioden oder anderen elektrische Bauteilen, die zwei Anschlüsse haben und als SMD-Elektronikbauteile erhältlich sind, auf den Anschlusselementen aufgebracht werden.

Ferner sei darauf hingewiesen, dass Merkmale, die mit Verweis auf eine der obigen Weiterentwicklungen beschrieben worden sind, auch in Kombination mit anderen Merkmalen anderer oben beschriebener Weiterentwicklungen verwendet werden können. Bezugszeichen in den Ansprüchen sind nicht als Einschränkung anzusehen.

## Patentansprüche

1. Sensormodul (101; 201; 301; 401) zur Aufnahme eines Drucksensorchips (104, 122; 204) und zur Montage in einem Sensorgehäuse (102, 117; 202, 217), aufweisend einen Modulboden (103) mit einem Chipmontagebereich, auf dem der Drucksensorchip montierbar ist;
eine monolithisch mit dem Modulboden ausgebildete und den Chipmontagebereich umlaufende Modulwand (105);
mehrere durch die Modulwand nach außen geführte Anschlusselemente (106; 206; 306; 406),
**dadurch gekennzeichnet, dass**
die Anschlusselemente zumindest im gesamten Außenbereich gerade verlaufen, und
die Anschlusselemente auf beiden Seiten, welche in entgegengesetzte Richtungen entlang einer Normalen zum Modulboden weisen, zumindest abschnittsweise zum Aufbringen und elektrischen Verbinden zumindest eines elektrischen Bauteils (113; 213; 313; 413) der Gruppe bestehend aus Kondensatoren, Widerständen, Dioden oder anderen elektrischen Bauteilen, die zwei Anschlüsse haben und als SMD-Elektronikbauteile erhältlich sind, und zur elektrischen Einbindung des Sensormoduls in das Sensorgehäuse freigelegt sind,
und wobei der Modulboden und die Modulwand monolithisch gegossen sind und sich im Außenbereich zwischen den Anschlusselementen ebenfalls Gussmaterial befindet, wobei sich im Außenbereich über zumindest 80% der Länge der Anschlusselemente im Außenbereich zwischen den Anschlusselementen Gussmaterial befindet und wobei die Anschlusselemente im Außenbereich mit Gussmaterial umgeben sind und nur die nach außen weisenden Endbereiche der Anschlusselemente auf beiden Seiten, welche in entgegengesetzte Richtungen entlang einer Normalen zum Modulboden weisen, sowie ein zum Aufbringen des zumindest einen elektrischen Bauteils ausgesparter Bereich, freigelegt sind.

2. Sensormodul gemäß Anspruch 1, des Weiteren mit einer Öffnung (118), die sich durch den Modulboden erstreckt und im Chipmontagebereich in das Sensormodul mündet.

3. Sensormodul gemäß Anspruch 1, wobei sich im Außenbereich, über die gesamte Länge der Anschlusselemente im Außenbereich, zwischen den Anschlusselementen Gussmaterial befindet.

4. Sensormodul gemäß Anspruch 1, wobei sich der Umfang des Sensormoduls ausgehend von der nach außen weisenden Seite des Modulbodens in einer Richtung normal zum Modulboden zunächst vergrößert und dann verkleinert.

5. System umfassend ein Sensormodul nach einem der vorhergehenden Ansprüche und zumindest zwei Sensorgehäuse (102, 117), wobei die nach außen weisende Seite des Modulbodens zur Montage an eine Innenseite des einen Sensorgehäuses angepasst ist, und der in die entgegengesetzte Richtung weisende Bereich der Modulwand zur Montage an eine Innenseite des anderen Sensorgehäuses angepasst ist.

6. System gemäß Anspruch 5, wobei die zumindest zwei Sensorgehäuse auf ihrer Innenseite eine Vertiefung (110, 116) aufweisen, wobei die nach außen weisende Seite des Modulbodens geometrisch an die Vertiefung des einen Sensorgehäuses angepasst ist, und der in die entgegengesetzte Richtung weisende Bereich der Modulwand geometrisch an die Vertiefung des anderen Sensorgehäuses angepasst ist.

7. System gemäß Anspruch 5, wobei die Seitenwände das Sensormoduls auf einer Seite, bezüglich einer Ebene in der die Anschlusselemente liegen, eine erste Neigung und auf der anderen Seite eine zweite Neigung gegenüber einer Normalen zum Modulboden aufweisen, und die Seitenwände der Vertiefung des einen Sensorgehäuses die erste Neigung und die Seitenwände der Vertiefung des anderen Sensorgehäuses die zweite Neigung aufweisen.

## Claims

1. Sensor module (101; 201; 301; 401) for receiving a pressure sensor chip (104, 122; 204) and for mounting in a sensor housing (102, 117; 202, 217), having a module base (103) with a chip mounting region on which the pressure sensor chip can be mounted;
a module wall (105) which is monolithically formed with the module base and surrounds the chip mounting region; a plurality of connection elements (106; 206; 306; 406) which are guided to the outside through the module wall, **characterized in that**
the connection elements run in a straight line at least in the entire outer region, and
the connection elements on both sides, which face in opposite directions along a normal to the module base, are exposed at least in sections for fitting and electrically connecting at least one electrical component (113; 213; 313; 413) from the group comprising capacitors, resistors, diodes or other electrical components which have two connections and are available as SMD electronic assemblies, and for electrically incorporating the sensor module into the sensor housing, and wherein the module base and the module wall are monolithically cast and cast material is likewise located in the outer region between the connection elements, wherein cast material is located in the outer region over at least 80% of the length of the connection elements in the outer region between the connection elements, and wherein the connection elements in the outer region are surrounded by cast material and only the outwardly facing end regions of the connection elements on both sides, which face in opposite directions along a normal to the module base, and also a region which is cut out for fitting the at least one electrical component are exposed.

2. Sensor module according to Claim 1, further having an opening (118) which extends through the module base and issues into the sensor module in the chip mounting region.

3. Sensor module according to Claim 1, wherein cast material is located in the outer region, over the entire length of the connection elements in the outer region, between the connection elements.

4. Sensor module according to Claim 1, wherein the circumference of the sensor module, starting from the outwardly facing side of the module base, initially increases in size and then decreases in size in a direction normal to the module base.

5. System comprising a sensor module according to one of the preceding claims and at least two sensor housings (102, 117), wherein the outwardly facing side of the module base is matched to an inner side of one sensor housing for mounting purposes, and that region of the module wall which faces in the opposite direction is matched to an inner side of the other sensor housing for mounting purposes.

6. System according to Claim 5, wherein the at least two sensor housings have a recess (110, 116) on their inner side, wherein the outwardly facing side of the module base is geometrically matched to the recess of one sensor housing, and that region of the module wall which faces in the opposite direction is geometrically matched to the recess of the other sensor housing.

7. System according to Claim 5, wherein the side walls of the sensor module have, on one side, with respect to a plane in which the connection elements lie, a first inclination and, on the other side, a second inclination in relation to a normal to the module base, and the side walls of the recess of one sensor housing have the first inclination and the side walls of the recess of the other sensor housing have the second inclination.

## Revendications

1. Module capteur (101 ; 201 ; 301 ; 401), destiné à recevoir une puce de capteur de pression (104, 122 ; 204) et à être monté dans un boîtier de capteur (102, 117 ; 202, 217), comportant un fond de module (103) doté d'une zone de montage de la puce, sur laquelle peut être montée la puce de capteur de pression ;
une paroi de module (105), conçue de manière monolithique avec le fond de module et entourant la zone de montage de la puce ;
plusieurs éléments de connexion (106 ; 206 ; 306 ; 406), guidés vers l'extérieur à travers la paroi de module,
**caractérisé en ce que**
les éléments de connexion s'étendent sous forme rectiligne, au moins dans l'ensemble de la zone extérieure, et
sur les deux côtés, qui dans des directions opposées sont tournés vers le fond de module, le long d'une normale, les éléments de connexion sont dénudés, au moins par segments, pour l'application et la connexion électrique d'au moins un composant électrique (113 ; 213 ; 313 ; 413) du groupe composé de condensateurs, de résistances, de diodes ou d'autres composants électriques détenant deux raccords et disponibles sous la forme de composants électriques SMD et pour l'intégration électrique du module capteur dans le boîtier de capteur,
et le fond de module et la paroi de module étant obtenus par moulage monolithique et dans la zone extérieure, entre les éléments de raccordement se trouvant également de la matière de fonte, dans la zone extérieure, sur au moins 80 % de la longueur des éléments de raccordement dans la zone extérieure se trouvant de la matière de fonte entre les éléments de raccordement et dans la zone extérieure, les éléments de raccordement étant enrobés de matière de fonte et seules les zones d'extrémité des éléments de raccordement qui sont tournés vers l'extérieur sur les deux côtés, qui dans des directions opposées sont tournés le long d'une normale vers le fond de module, ainsi qu'une zone évitée pour le montage de l'au moins un composant électrique étant dénudées.

2. Module capteur selon la revendication 1, doté par ailleurs d'un orifice (118), qui s'étend à travers le fond de module et qui dans la zone de montage de la puce débouche dans le module capteur.

3. Module capteur selon la revendication 1, dans la zone extérieure, sur toute la longueur des éléments de connexion, dans la zone extérieure, entre les éléments de raccordement se trouvant de la matière de fonte.

4. Module capteur selon la revendication 1, en partant du côté du fond de module tourné vers l'extérieur, la périphérie du module capteur s'agrandissant d'abord et se rétrécissant par la suite, dans une direction à la normale vers le fond de module.

5. Système, comprenant un module capteur selon l'une quelconque des revendications précédentes et au moins deux boîtiers de capteur (102, 117), le côté tourné vers l'extérieur du fond de module étant adapté pour le montage sur la face intérieure de l'un des boîtiers de capteur et la zone de la paroi de module montrant dans la direction opposée étant adaptée pour le montage sur une face intérieure de l'autre boîtier de capteur.

6. Système selon la revendication 5, sur leur face intérieure, les au moins deux boîtiers de capteur comportant un creux (110, 116), le côté montrant vers l'extérieur du fond de module étant géométriquement adapté au creux de l'un des boîtiers de capteur et la zone tournée dans la direction opposée de la paroi de module étant géométriquement adaptée au creux de l'autre boîtier de capteur.

7. Système selon la revendication 5, sur un côté, en rapport à un plan dans lequel se situent les éléments de connexion, les parois latérales du module capteur comportant une première inclinaison et sur l'autre côté, comportant une deuxième inclinaison au regard d'une normale vers le fond de module et les parois latérales du creux de l'un des boîtiers de capteur comportant la première inclinaison et les parois latérales du creux de l'autre boîtier de capteur comportant la deuxième inclinaison.
